# EUROPEAN PATENT APPLICATION

(11) **EP 2 081 178 A2**
(43) Date of publication of application: **22.07.2009**
(21) Application number: 09250107.1
(22) Date of filing: 16.01.2009
(51) Int. Cl.: G09G 3/32

(54) **Organic light emitting display device**

(30) Priority: 18.01.2008 KR 20080005618
(71) Applicant: Samsung Mobile Display Co., Ltd., Suwon-si Gyeonggi-do (KR)
(72) Inventor: Kim, Tae-Jin, Gyeonggi-do (KR); Kim, Keum-Nam, Gyeonggi-do (KR); Seo, Hae-Kwan, Gyeonggi-do (KR); Gu, Bon-Seog, Gyeonggi-do (KR)
(74) Representative: Taor, Simon Edward William

(57) **Abstract**

An organic light emitting display capable of minimizing the voltage drop of pixel power sources supplied to an organic light emitting display panel, contemplates an organic light emitting display panel including a pixel unit on which an image is displayed, and a plurality of first and second power source pads provided at two or more edges outside the pixel unit in order to receive first and second pixel power sources in at least two different directions, a plurality of tape carrier packages (TCP) electrically coupled to the organic light emitting display panel and including driving ICs for driving the organic light emitting display panel and power source lines for transmitting the first and second pixel power sources to the first and second power source pads, and driving boards electrically coupled to the TCPs in order to supply control signals for controlling the driving ICs and the first and second pixel power sources to the TCPs.

## Description

### BACKGROUND OF THE INVENTION

### Field of the Invention

The present invention relates to an organic light emitting display device, and more particularly, to an organic light emitting display device capable of minimizing a voltage drop of pixel power sources supplied to an organic light emitting display panel.

### Description of the Related Art

Among flat panel display (FPD) devices, the organic light emitting display devices display images using organic light emitting diodes (OLEDs) that generate light by re-combination of electrons and holes. Since the organic light emitting display device has high response speed and is driven with low power consumption, the organic light emitting display device is spotlighted as a next generation display device.

Generally, the organic light emitting display device contemplates a pixel unit including a plurality of pixels, driving circuits for supplying driving signals to the pixel unit, and a power source supplying circuit for supplying pixel power sources to the pixel unit.

The pixels emit light with brightness corresponding to data signals supplied in synchronization with scan signals when the scan signals are supplied. Therefore, the organic light emitting display panel display device displays a predetermined image.

In the organic light emitting display device, the emission brightness of the pixels is affected by the voltage of the pixel power sources. That is, the pixel power sources determine the emission brightness of the pixels together with the data signals.

Therefore, in order to display an image with a uniform picture quality, the pixel power sources having the same voltage are to be supplied to each of the pixels.

A voltage drop IR Drop may however be generated while current passes through power source lines, because pixel power sources are direct current (DC) power sources having a predetermined voltage level.

In particular, the length of the power source lines increases when the size of the display panel of the organic light emitting display increases, therefore, a brightness variation between the pixels may increase in accordance with the distance between the pixels and a power source pad that receives the pixel power sources.

Therefore, a method of minimizing the voltage drop of the pixel power sources is required.

### SUMMARY OF THE INVENTION

It is therefore an object of the present invention to provide an improved organic light emitting display device in order to achieve a uniform picture quality of the organic light emitting display device.

It is another object of the present invention to provide an organic light emitting display device capable of minimizing the voltage drop of pixel power sources supplied to an organic light emitting display panel.

In order to achieve the foregoing and/or other objects of the present invention, an organic light emitting display device according to an aspect of the present invention comprises: an organic light emitting display panel having a pixel unit on which an image is displayed, and a plurality of first and second power source pads provided at two or more edges surrounding the pixel unit to receive first and second pixel power sources in at least two directions; a plurality of tape carrier packages (TCP) electrically coupled to the organic light emitting display panel, and including driving ICs for driving the organic light emitting display panel and power source lines for transmitting the first and second pixel power sources to the first and second power source pads; and driving boards electrically coupled to the TCPs in order to supply control signals for controlling the driving ICs and the first and second pixel power sources to the TCPs. Therefore, the organic light emitting display panel can respectively receive the first and second pixel power sources from at least two directions.

Additionally, the organic light emitting display panel may further include a plurality of signal pads formed between the first and second power source pads to supply driving signals to the pixel unit. In some embodiments, the TCPs may include a first pad unit electrically coupled to at least one of the first and second pads and the signal pads and a second pad unit electrically coupled to the driving boards and the last pads positioned on at least one side of the first pad may be electrically coupled to at least one of the first and second power source pads. The last pads positioned at least one side of each of the first pad unit and the second pad unit may be coupled to each other by the power source lines.

In addition, the first power source pads may be formed at a first edge of the organic light emitting display panel and a second edge that faces the first edge and the second power source pads may be formed in a third edge of the organic light emitting display device and a fourth edge that faces the third edge. In some embodiments, the plurality of the first power source pads may be formed at the first and second edges respectively and the plurality of the second power source pads may be formed at the third and fourth edges respectively. In addition, the first and second power source pads may be formed at different edges of the organic light emitting display panel. In other embodiments, one edge of the organic light emitting display panel may be provided with both the first second power source pads.

According to a first aspect of the invention, there is provided an organic light emitting display device, comprising: an organic light emitting display panel comprising a pixel unit for displaying an image, a plurality of first power source pads arranged to receive a first pixel power source, and a plurality of second power source pads arranged to receive a second pixel power source, wherein the first and second power source pads are both provided at two or more edges of the pixel unit; a plurality of tape carrier packages (TCP) electrically coupled to the organic light emitting display panel and including driving integrated circuits (ICs) for driving the organic light emitting display panel and power source lines for respectively transmitting the first or second pixel power sources to the first or second power source pads; and driving boards electrically coupled to the plurality of TCPs arranged to supply control signals for controlling the driving ICs and the first and second pixel power sources to the plurality of TCPs. Preferred features of this aspect are set out in claims 2 to 8. According to a second aspect of the present invention, there is provided an organic light emitting display device, comprising: an organic light emitting display panel comprising a pixel unit on which an image is displayed, and a plurality of first and second power source pads provided on at least two different edges surrounding the pixel unit in order to receive first and second pixel power sources in at least two different directions; a plurality of tape carrier packages (TCP) being electrically coupled to the organic light emitting display panel, and including driving integrated circuits (ICs) for driving the organic light emitting display panel and power source lines for respectively transmitting the first and second pixel power sources to the first and second power source pads; driving boards electrically coupled to the plurality of TCPs to supply control signals for controlling the driving ICs and the first and second pixel power sources to the plurality of TCPs; and the TCPs comprising a pad unit electrically coupled to at least one of the first and second power source pads and the signal pads, and pads positioned at edges of at least one side of the pad unit being electrically coupled to at least one of the first and second power source pads.

In the present invention, by providing the first and second power sources to power source pads along different edges of the organic light emitting display panel, it is possible to minimise the distance between the pixels and the power source pads that receive the pixel power sources. This helps minimise the problem of a voltage drop IR Drop causing a brightness variation between the pixels.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicated the same or similar components, wherein:

FIG. 1 is a block diagram illustrating an example of an organic light emitting display device constructed as the present invention;

FIG. 2 is a circuit diagram illustrating an example of the pixel of FIG. 1;

FIG. 3 is an exploded perspective view of an organic light emitting display panel and a tape carrier package (TCP) constructed as an embodiment of the present invention;

FIG. 4 is an enlarged plan view of the TCP illustrated in FIG. 3;

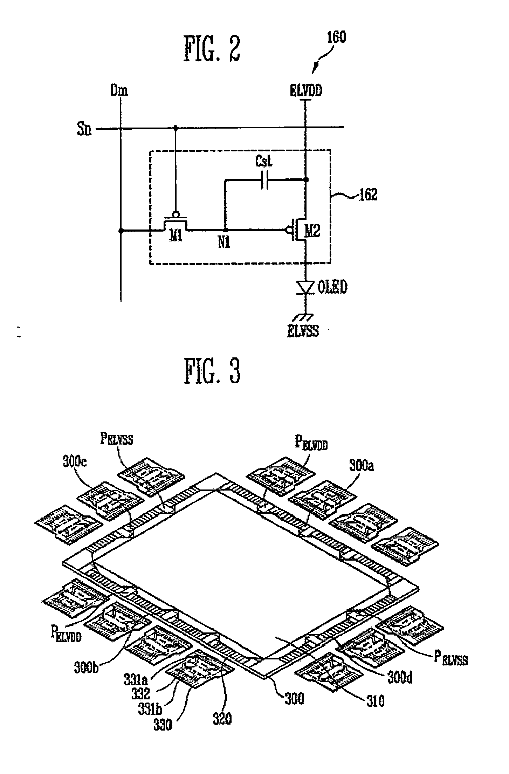

FTG. 5 is a coupled perspective view of the organic light emitting display panel and the TCP in FIG. 3; and

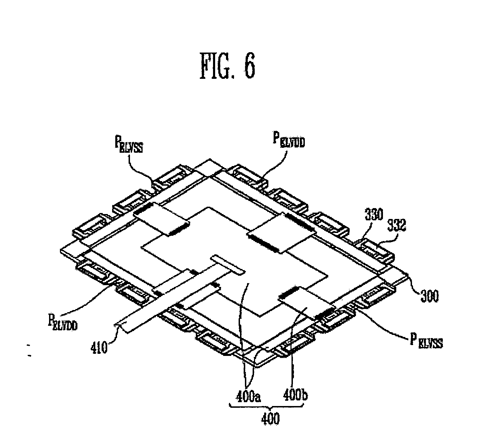

FIG. 6 is a coupled perspective view of an organic light emitting display device constructed as an embodiment of the present invention.

### DETAILED DESCRIPTION OF THE INVENTION

Hereinafter, certain embodiments according to the present invention will be described with reference to the accompanying drawings. Here, when a first element is described as being coupled to a second element, the first element may be not only directly coupled to the second element but may also be indirectly coupled to the second element via a third element. Further, some of the elements that are not essential to the complete understanding of the invention are omitted for clarity. Also, like reference numerals refer to like elements throughout.

Hereinafter, embodiments of the present invention will be described in detail with reference to the accompanying drawings.

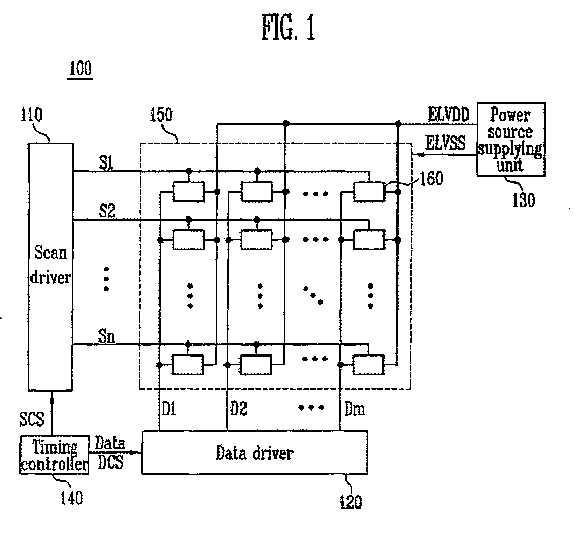

FIG. 1 is a block diagram illustrating an example of an organic light emitting display device constructed as the present invention.

Referring to FIG. 1, an organic light emitting display device 100 includes a scan driver 110, a data driver 120, a timing controller 140, a pixel unit 150, and a power source supplying unit 130.

Scan driver 110 generates scan signals to correspond to scan driving control signals SCS supplied from timing controller 140. The scan signals generated by scan driver 110 are sequentially supplied to scan lines S 1 to Sn.

Data driver 120 generates data signals to correspond to data Data and data driving control signals DCS supplied from timing controller 140. The data signals generated by data driver 120 are supplied to data lines D1 to Dm in synchronization with the scan signals.

Timing controller 140 generates the scan driving control signals SCS and the data driving control signals DCS in response to synchronizing signals supplied from the exterior. The scan driving control signals SCS generated by timing controller 140 are supplied to scan driver 110 and the data driving control signals DCS are supplied to data driver 120. In addition, timing controller 140 transmits the data Data supplied from the exterior to data driver 120.

Pixel unit 150 includes a plurality of pixels 160 formed in regions partitioned off by the scan lines S1 to Sn and the data lines D1 to Dm. Pixel unit 150 displays an image to correspond to the scan signals supplied from scan driver 110 and the data signals supplied from data driver 120.

Power source supplying unit 130 generates first and second pixel power sources ELVDD and ELVSS using an external power source supplied from an external power source supplying apparatus (not shown). Then, power source supplying unit 130 supplies the generated first and second pixel power sources ELVDD and ELVSS to pixel unit 150.

In organic light emitting display device 100, pixel unit 150 is formed in the organic light emitting display panel. Scan driver 110 and/or data driver 120 is mounted on the organic light emitting display panel. Or scan driver 110 and/or data driver 120 is mounted on an additional flexible printed circuit board (FPCB) or tape carrier package (TCP) film in type of an integrated circuit chip, and scan driver 110 and/or data driver 120 may be electrically coupled to the organic light emitting display panel through a pad unit.

Additionally, power source supplying unit 130 and/or timing controller 140 are mounted on a driving board outside the organic light emitting display panel to be electrically coupled to the organic light emitting display panel and/or the driving FPCBs through the FPCB and/or the TCP.

FIG. 2 is a circuit diagram illustrating an example of the pixel that could be used in the embodiment of FIG. 1. For convenience, in FIG. 2, a pixel coupled to an nth scan line Sn and an mth data line Dm will be illustrated.

Referring to FIG. 2, a pixel 160 includes an organic light emitting diode OLED, and a pixel circuit 162 electrically coupled to the scan line Sn, the data line Dm, a first pixel power source ELVDD and the OLED.

The anode electrode of the OLED is electrically coupled to pixel circuit 162 and the cathode electrode is electrically coupled to the second pixel power source ELVSS. The OLED emits light with the brightness corresponding to the amount of current supplied from pixel circuit 162.

Pixel circuit 162 includes a first transistor M1, a second transistor M2, and a storage capacitor Cst.

The first electrode of the first transistor M1 is electrically coupled to the data line Dm and the second electrode of the first transistor M1 is electrically coupled to a first node N1. The gate electrode of the first transistor M1 is electrically coupled to the scan line Sn. The first transistor M1 is turned on when a scan signal is supplied to the scan line Sn to transmit a data signal supplied to the data line Dm to the first node N1.

The first electrode of the second transistor M2 is electrically coupled to the first pixel power source ELVDD and the second electrode of the second transistor M2 is electrically coupled to the anode electrode of the OLED. The gate electrode of the second transistor M2 is coupled to the first node N1. The second transistor M2 controls current that flows from the first pixel power source ELVDD to the anode electrode of the OLED to correspond to a voltage supplied to the gate electrode of the second transistor M2.

One terminal of a storage capacitor Cst is electrically coupled to the first node N1 and the other terminal of the storage capacitor Cst is electrically coupled to the first pixel power source ELVDD and the first electrode of the second transistor M2. The storage capacitor Cst stores a voltage corresponding to a data signal supplied to the first node N1 when the scan signal is supplied to the scan line Sn and maintains the stored voltage in one frame.

The operation process of pixel 160 will be described in detail. First, when the scan signal is supplied to the scan line Sn, the first transistor M1 is turned on. When the first transistor M1 is turned on, the data signal supplied to the data line Dm is transmitted to the first node N1 through the first transistor M1. When the data signal is transmitted to the first node N1, a voltage corresponding to a difference between the voltage of the first pixel power source ELVDD and the data signal is charged in the storage capacitor Cst. Then, the second transistor M2 controls current that flows from the first pixel power source ELVDD to the OLED to correspond to a voltage supplied to the gate electrode of the second transistor M2. Therefore, the OLED emits light with brightness corresponding to the amount of current supplied thereto to display an image.

As described above, pixel 160 emits light with brightness corresponding to the amount of current supplied from the second transistor M2. Here, the voltage of the first node N1 to which the gate electrode of the second transistor M2 is electrically coupled is maintained in one frame by the storage capacitor Cst.

The storage capacitor Cst charges a voltage corresponding to a difference between the voltage of the first pixel power source ELVDD and the data signal while the data signal is supplied to maintain the voltage in one frame. Therefore, the emission brightness of pixel 160 varies in accordance with the voltage of the first pixel power source ELVDD and the data signal.

Here, the voltage of the first pixel power source ELVDD supplied to pixels 160 may vary by the voltage drop generated while passing through power source lines. Therefore, pixels 160 that receive the same data signal may emit light with different brightness so that picture quality can deteriorate.

Therefore, a method of minimizing the voltage drop of the first pixel power source ELVDD is to be found. According to the present invention, the method will be provided through the embodiments to be mentioned later.

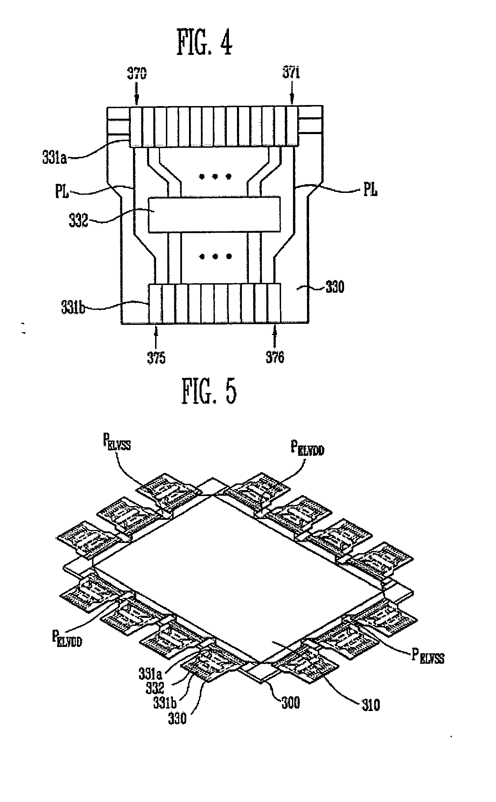

FIG. 3 is an exploded perspective view of an organic light emitting display panel and a tape carrier package (TCP) constructed as an embodiment of the present invention. FIG. 4 is an enlarged plan view of a TCP illustrated in FIG. 3. FIG. 5 is a coupled perspective view of the organic light emitting display panel and the TCP in FIG. 3.

In FIGs. 3 through 5, driving ICs including the scan driver and/or the data driver are not mounted on the organic light emitting display panel but are mounted on an additional tape carrier package (TCP). The present invention, however, is not limited to the above. In addition, in FIG. 4, one side of the TCP on which the driving IC is mounted is illustrated.

Referring to FIGs. 3 through 5, an organic light emitting display panel 300 includes a pixel unit 310 and a plurality of power source pads P_{ELVDD} and P_{ELVSS} and signal pads 320. In this embodiment, the organic light emitting display panel 300 is rectangular in shape, and the plurality of power source pads P_{ELVDD} and P_{ELVSS} and signal pads 320 are positioned at edges 300a, 300b, 300c and 300d outside pixel unit 310 to supply pixel power sources ELVDD and ELVSS and driving signals to pixel unit 310. Other embodiments of the invention may employ organic light emitting display panels of other shapes, for example with a different number of edges.

Pixel unit 310 includes a plurality of pixels that are not shown. Pixel unit 310 displays an image to correspond to the driving signals supplied from signal pads 320 and the pixel power sources ELVDD and ELVSS supplied from the power source pads P_{ELVDD} and P_{ELVSS}.

Each of the power source pads P_{ELVDD} and P_{ELVSS} are provided at two or more edges of organic light emitting display panel 300.

To be specific, the power source pads P_{ELVDD} and P_{ELVSS} include the first power source pads P_{ELVDD} that receive the first pixel power source ELVDD and the second power source pads P_{ELVSS} that receive the second pixel power source ELVSS.

In this embodiment, the first and second power source pads P_{ELVDD} and P_{ELVSS} are each dispersed along two or more edges of the organic light emitting display panel 300 in order to receive both the first and second pixel power sources ELVDD and ELVSS from two opposite directions that face each other. The first and second pixel power sources ELVDD and ELVSS are provided from TCPs 330 that are electrically coupled to the organic light emitting display panel 300.

For example, the plurality of the first power source pads P_{ELVDD} may be formed along the first and second edges 300a and 300b that face each other in organic light emitting display 300. Therefore, the first power source pads P_{ELVDD} may receive the first pixel power source ELVDD from two opposite directions and thus transmit the first pixel power source ELVDD to pixel unit 310. In other words, in this embodiment, the first power source pads P_{ELVDD} along the first edge 300a may receive the first pixel power source ELVDD from a first direction, and the first power source pads P_{ELVDD} along the second edge 300b may receive the first pixel power source ELVDD from a second direction (that is opposite to the first direction). By providing the first power source ELVDD to power source pads P_{ELVDD} along two different edges of the organic light emitting display panel, it is possible to minimise the distance between the pixels and the power source pads P_{ELVDD} that receive first power source ELVDD.

The plurality of the second power source pads P_{ELVSS} may be formed at the third and fourth edges 300c and 300d that face each other in organic light emitting display panel 300 respectively. Therefore, the second power source pads P_{ELVSS} receive the second pixel power source ELVSS from both directions and thus transmit the second pixel power source ELVSS to pixel unit 310. In other words, in this embodiment, the second power source pads P_{ELVSS} along the third edge 300c will receive the second power source ELVSS from an opposite direction to the second power source pads P_{ELVSS} along the fourth edge 300d. By providing the second power source ELVSS to power source pads P_{ELVSS} along two different edges of the organic light emitting display panel, it is possible to minimise the distance between the pixels and the power source pads P_{ELVSS} that receive second power source ELVSS.[0056] That is, the first power source pads P_{ELVDD} and the second power source pads P_{ELVSS} may be formed at different edges of organic light emitting display panel 300.

The arrangement of the power source pads P_{ELVDD} and P_{ELVSS} according to the present invention is not limited to the embodiment discussed above. That is, the first and second power source pads P_{ELVDD} and P_{ELVSS} can both be provided at three or more edge regions of the organic light emitting display panel 300. Therefore, the first and second power source pads P_{ELVDD} and P_{ELVSS} may receive the first and second pixel power sources ELVDD and ELVSS from at least three different directions (via at least three corresponding edges). In this case, at least some of the first and second power source pads P_{ELVDD} and P_{ELVSS} may be formed at the same edge of organic light emitting display panel 300. In other words, in some embodiments, both a number of the first power source pads P_{ELVDD} and a number of the second power source pads P_{ELVSS} may be located along the same edge of the organic light emitting display panel 300. For example, in some embodiments the first power source pads P_{ELVDD} and the second power source pads P_{ELVSS} may be each located along every edge of the organic light emitting display panel 300.

Signal pads 320 transmit the driving signals supplied from TCPs 330 to pixel unit 310. The plurality of signal pads 320 may be provided between the first and second power source pads P_{ELVDD} and P_{ELVSS} receptively.

The plurality of TCPs 330 electrically coupled to signal pads 320 may be provided.

Driving ICs 332 for driving organic light emitting display panel 300, in particular, pixel units 310 are mounted on the TCPs 330.Scan driving circuits and/or data driving circuits are mounted onto the driving ICs 332.

The TCPs 330 include first and second pad units 331a and 331b. Each first pad unit 331a is electrically coupled to at least one of the first and second power source pads P_{ELVDD} and P_{ELVSS} of organic light emitting display panel 300 and to a signal pad 320. That is, the first pad units 331a electrically couple organic light emitting display panel 300 and TCPs 330. The second pad units 331b are electrically coupled to driving boards (not shown). That is, the second pad units 331b electrically couple the driving boards and the TCPs 330 to each other.

TCPs 330 supply the driving signals such as the scan signals and/or the data signals generated by driving ICs 332 to the organic light emitting display 300 corresponding to control signals supplied from the driving boards.

In some embodiments of to the present invention, power source lines PL for transmitting the first and second pixel power sources ELVDD and ELVSS from the driving boards are provided as internal lines of the TCPs 330. At least one side of each of the first pad units 331a (i.e., at least one of pads 370 and 371), for example, both of pads 370 and 371 disposed at edges of the first pad units 331a is electrically coupled to one of the first or second power source pads P_{ELVDD} and P_{ELVSS}. Here, at least one side of each of the first pad units 331a (for example, both of pads 370 and 371) may extend to the first and/or second power source pads P_{ELVDD} and P_{ELVSS}. In some embodiments, the first pad units 331a comprise a row of pads, with pads 370 and 371 disposed at respective ends of the row, with pads 370 and 371 being respectively connected to one of the first or second power source pads P_{ELVDD}, P_{ELVSS}.

Pads 370 and 371 are disposed at edge of at least one side of each of the first pad units 331a, and are respectively electrically coupled to pads 375 and 376 positioned at edge of at least on one side of each of the corresponding second pad units 331b. Therefore, in some embodiments, the power source lines PL respectively electrically couple the pads positioned at edge of at least one side of the first pad unit 331a to the corresponding pads on the second pad unit 331b. Here, since the plurality of TCPs 330 are provided, as many power source lines PL as the number of the first and second power source pads P_{ELVDD} and P_{ELVSS} may be formed. In other words, in some embodiments, the second pad units 331b comprise a row of pads, with pads 375 and 376 being disposed at respective ends of the row, and with pads 370 and 371 respectively electrically coupled to pads 375 and 376 via the power source lines PL.

FIG. 6 is a coupled perspective view of an organic light emitting display constructed as an embodiment of the present invention. In the description of FIG. 6, the same parts as the parts of FIGs. 3 through 5 are denoted by the same reference numerals and detailed description thereof will be omitted.

Referring to FIG. 6, the plurality of TCPs 330 are electrically coupled to the organic light emitting display panel 300. Driving boards 400 are electrically coupled to TCPs 330, with the driving boards 400 being provided on one side of organic light emitting display panel 300, for example, on the opposite side from which an image is displayed.

The, driving boards 400 include interfaces 410 for transmitting signals and/or power sources supplied from the exterior or boards 400a electrically coupled to TCPs 330 and flexible printed circuit boards (FPCBs) 400b electrically coupled to boards 400a. This structure is merely one embodiment of the present invention and the present invention is not limited to the above.

Timing controllers and/or power source supplying units (not shown) are mounted on the driving boards 400 so that the driving boards 400 may generate control signals for controlling the driving ICs 332 and the first and second pixel power sources ELVDD and ELVSS.

Driving boards 400 supply the control signals and the first and second pixel power sources ELVDD and ELVSS to the TCPs 330 through the second pad units 331b illustrated in FIGs. 3 to 5.

According to the embodiments of the present invention described above with reference to FIGs. 3 to 6, the power source pads P_{ELVDD} and P_{ELVSS} of the organic light emitting display panel 300 may be provided at two or more edges. Therefore, the first and second pixel power sources ELVDD and ELVSS are supplied to organic light emitting display panel 300 in at least two different directions.

Therefore, it is possible to minimize the voltage drop of the first and second pixel power sources ELVDD and ELVSS in organic light emitting display panel 300. Therefore, although the size of organic light emitting display panel 300 increases, it is possible to display an image of uniform picture quality. Therefore, the organic light emitting display may be applied to various displays such as a TV and a sign board.

Additionally, in embodiments of the present invention, power source lines PL for coupling the power source pads P_{ELVDD} and P_{ELVSS} provided at the edges of organic light emitting display panel 300 to driving boards 400 on which the power source supplying units are mount are provided in TCPs 330 on which the driving ICs (for example, the scan driver and/or the data driver) are mounted.

Therefore, the pixel power sources ELVDD and ELVSS may be uniformly applied to the inside of organic light emitting display 300 without including additional FPCBs or PCBs. Therefore, it is possible to reduce manufacturing cost and to simplify the structure of a module.

While the present invention has been described in connection with certain embodiments, it is to be understood that the invention is not limited to the disclosed embodiments, but, on the contrary, is intended to cover various modifications and equivalent arrangements included within the scope of the appended claims, and equivalents thereof.

## Claims

1. An organic light emitting display device, comprising:
an organic light emitting display panel comprising a pixel unit for displaying an image, a plurality of first power source pads arranged to receive a first pixel power source, and a plurality of second power source pads arranged to receive a second pixel power source, wherein the first and second power source pads are both provided at two or more edges of the pixel unit so as to respectively receive the first or second pixel power sources from at least two directions;
a plurality of tape carrier packages (TCP) electrically coupled to the organic light emitting display panel and including driving integrated circuits (ICs) for driving the organic light emitting display panel and power source lines for respectively transmitting the first or second pixel power sources to the first or second power source pads; and
driving boards electrically coupled to the plurality of TCPs arranged to supply control signals for controlling the driving ICs and the first and second pixel power sources to the plurality of TCPs.

2. An organic light emitting display device according to claim 1, wherein the organic light emitting display panel further comprises a plurality of signal pads respectively formed between one of a said first or second power source pad and another of a said first or second power source pad, the signal pads being for supplying driving signals to the pixel unit.

3. An organic light emitting display device according to claim 2, wherein each TCP further comprises:
a first pad unit electrically coupled to at least one of the first and second power source pads and to a said signal pad; and
a second pad unit electrically coupled to at least one driving board; and
wherein the first pad unit comprises a row of pads, and at least one of the pads at the end of the row of pads in the first pad unit is electrically coupled to at least one of the first and second power source pads.

4. An organic light emitting display device as according to claim 3, wherein the second pad unit comprises a row of pads, and at the pads at the ends of the row of pads of the first pad unit are each electrically coupled to a pad at a corresponding end of the row of pads of the second pad unit by the power source lines.

5. An organic light emitting display device according to any preceding claim,
wherein the first power source pads are formed at both a first edge of the organic light emitting display panel and a second edge that faces the first edge, and
wherein the second power source pads are formed at both a third edge of the organic light emitting display and a fourth edge that faces the third edge.

6. An organic light emitting display device according to any of claims 1 to 4,
wherein the plurality of the first power source pads are formed at first and second edges of the organic light emitting display panel.

7. An organic light emitting display device according to any of claims 1 to 4,
wherein the plurality of the second power source pads are formed at the third and fourth edges of the organic light emitting display panel.

8. An organic light emitting display device according to any preceding claim,
wherein the first and second power source pads are formed at different edges of the organic light emitting display panel to each other.
